# NEW EUROPEAN PATENT SPECIFICATION

(11) **EP 1 233 665 B2**
(45) Date of publication and mention of the opposition decision: **20.11.2013**
(45) Mention of the grant of the patent: 23.11.2005
(21) Application number: 02006758.3
(22) Date of filing: 06.09.1999
(51) Int. Cl.: H05K 5/02, H04B 1/38

(54) **Rechargeable battery powered portable heavy duty audio equipment**
Nachladbare Batterie angetriebenes tragbares zwangsbeständige Audiogerät
Dispositif audiophonique portatif actionné par pile rechargeable et résistant aux contraintes

(30) Priority: 15.09.1998 US 153621; 04.03.1999 US 262751
(43) Date of publication of application: 21.08.2002
(62) Divisional of application: 99307059.8
(73) Proprietor: Black & Decker Inc., Newark, DE 19711 (US)
(72) Inventor: Smith, Roger Q., Reisterstown, Maryland 21136 (US)
(74) Representative: Bell, Ian Stephen

(56) References cited:
- US-A- 4 089 044
- US-A- 5 424 725

## Description

This invention relates generally to audio equipment and, more particularly, to heavy-duty radios.

It is well known that audio equipment, such as portable radios, are taken to construction sites, so that the construction workers can listen to music, talk shows, etc., while working. However, the audio equipment may be destroyed at the jobsite because tools may be dropped on them. Similarly, the equipment may fall from a table, etc., resulting in damage thereto.

It is therefore an object of this invention to provide an audio equipment that can withstand the rigors of a jobsite.

Furthermore, because construction workers have different cordless power tools, it would be beneficial if the audio equipment would receive the rechargeable battery packs used with the power tools in order to charge the battery packs and/or power the audio equipment.

In accordance with the present invention, audio equipment according to claim 1 is provided.

Additional features and benefits of the present invention are described, and will be apparent from, the accompanying drawings and the detailed description below.

The accompanying drawings illustrate preferred embodiments of the invention according to the practical application of the principles thereof, and in which:
FIG. 1 is a front elevational of an audio equipment according to the present invention;
FIG. 2 is a rear elevational view of the audio equipment of FIG. 1;
FIG. 3 is a side elevational view of the audio equipment of FIG. 1;
FIG. 4 is a cross-sectional view along line IV-IV of FIG. 3;
FIG. 5 is a block diagram of the circuitry of the audio equipment of FIG. 1; and
FIG. 6 is a cross-sectional view along line VI-VI of FIG. 2.

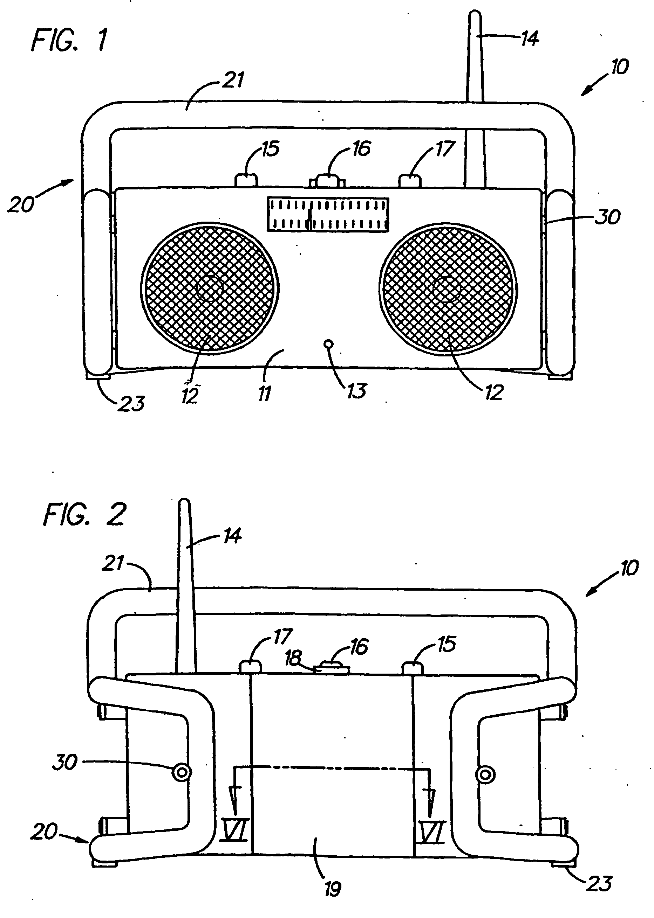

The invention is now described with reference to the accompanying figures, wherein like numerals designate like parts. Referring to FIGS. 1-3, an audio equipment component, such as radio 10, of the present invention comprises a housing 11. Housing 11 may support the radio circuitry (not shown), the speakers 12 connected to the radio circuitry, the volume, tuning and switch knobs (15, 16 and 17 respectively), antenna 14, and auxiliary input jack 13.

Preferably speakers 12 and part of housing 11 are coated with a waterproof coating, such as a rubber coating or paint. Alternatively, other waterproofing schemes may be used for protecting the speakers 12. For example, US Patent Nos. 3,391,754, 2,829,728, and 2,517,138 disclose appropriate waterproofing schemes and are hereby incorporated by reference.

The knobs may also comprise waterproofing means for impeding entry of water into housing 11. Such means may include walls created on the housing 11 and/or the knobs, creating a labyrinth passage for water. Alternatively, other waterproofing schemes may be used for the knobs. For example, US Patent Nos. 3,391,754, 3,277,739, 2,502,915 and 1,162,793 disclose appropriate waterproofing schemes and are hereby incorporated by reference.

Antenna 14 is preferably constructed of a flexible material, allowing antenna 14 to bend without breaking.

Preferably, at least one protective covering, shield, or shell is flexibly connected to the housing 11. An example of this protective covering is protective bar 20. Such covering or shield, e.g., bar 20, may be made of aluminum, or other suitable material. Preferably, covering or shield, e.g., bar 20 is made of a plastic, such as ABS or polypropylene. The covering or shield, e.g., bar 20, may be injection-molded. Alternatively, when the covering or shield is shaped as a bar, the plastic may be injected into a mold (preferably about half the volume needed to complete fill the mold and thus filling half of the mold), then air or gas is blown therein, pushing the plastic into the other half of the mold, forming a hollow tube. This process is known as gas-assist injection molding.

Preferably, the protective covering or shield is comprised of two bars 20 which are formed in respective loops and are connected to a respective side of housing 11. The protective covering or shield may also include a handle 21, which may be fixedly attached to the bars 20 via, e.g., screws (not shown). Preferably, the shape of bars 20 and/or handle 21 is such that the housing 11 cannot be contacted by anything wider than the handle 21 and/or bars 20. Such construction minimizes the risk of damage to housing 11, but still allows access to the working components of the radio and/or does not muffle the sound produced by the speakers.

Persons skilled in the art will recognize that the protective shield or bar 20 are preferably are releasably attached to the housing by coacting fasteners, such as screws, bolts, etc. By adapting protective shield or bar 20 in this manner, a user can replace parts of the protective shield or one bar 20 when damaged without incurring the expense of replacing entire shield, all bars 20 or radio 10.

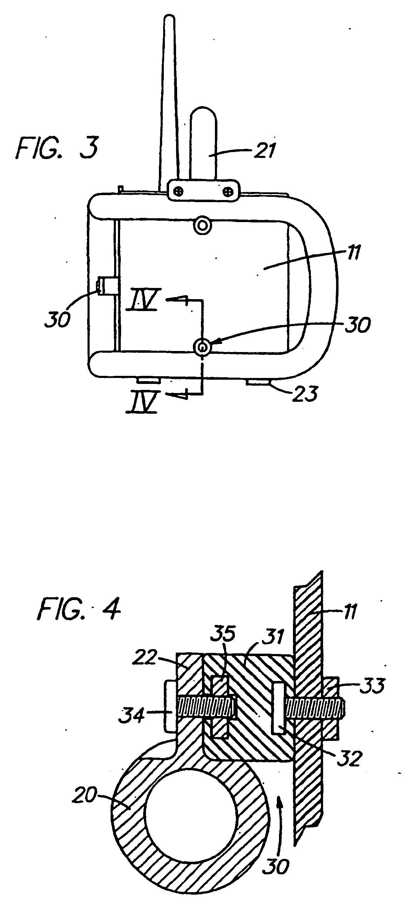

As mentioned above, the protective shield or bars 20 may be flexibly connected to the housing. Such connection is achieved via the connector assemblies 30. Referring to FIG. 4, a connector assembly 30 is disposed between the bar 20 and housing 11. The connector assembly 30 comprises a flexible gasket 31, which is preferably made of a flexible, resilient material such as rubber or an elastometer. The gasket 31 may be connected to the bar 20 via a screw 34 threadedly engaging a nut 35. The gasket 31 in turn may be connected to the housing 11 via a screw 32 threadedly engaging a nut 33. Gasket 31 may be molded over screw 32 and/or nut 35. Such construction minimizes the shock received by housing 11, and thus by the circuitry mounted within, when radio 10 is dropped.

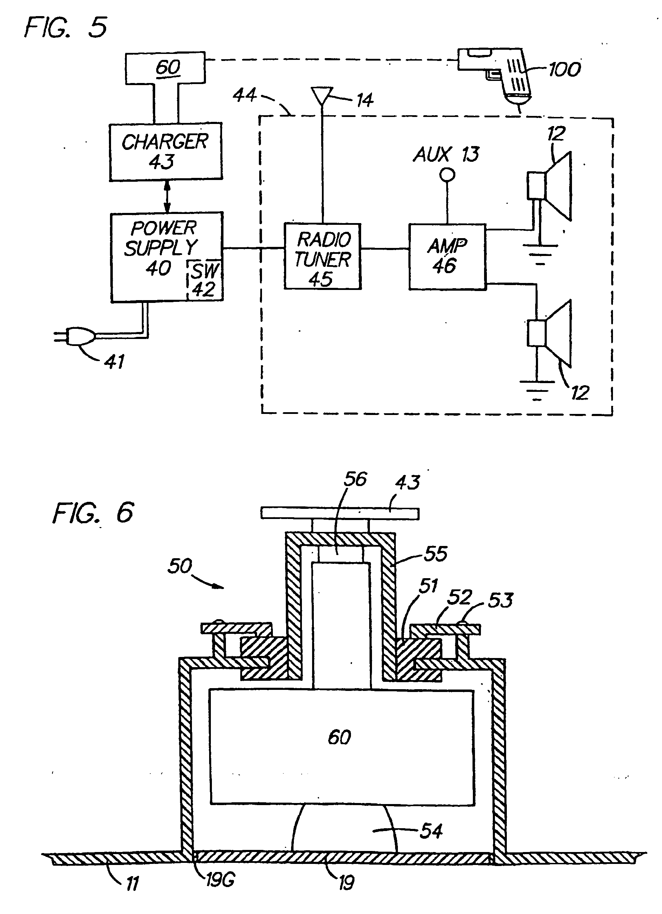

Referring to FIGS. 2 and 6, housing 11 may also have a door 19 pivotally attached thereto, providing access to receptacle assembly 50 and allowing an operator to install a battery pack 60 within housing 11. The door 19 may be kept in a closed position by latch 18. Preferably, latch 18 comprises an overcenter mechanism.

Door 19 may have a gasket 19G disposed thereon to limit the ingress of water into, if not wholly waterproof, receptacle assembly 15. Preferably gasket 19G is made of rubber or an elastomeric material. Persons skilled in the art will recognize that the gasket 19G may be disposed on housing 11 and perform the same function.

Receptacle assembly 50 is designed to receive a battery pack 60 via a connector 56. The connector 56 has a configuration appropriate to contact the battery terminals. Preferably the battery pack terminals and connector 56 will be arranged in the manner disclosed in U.S. Patent No. 5,144,217, which is hereby incorporated in whole by reference.

The charger circuitry 43 may be fixedly connected to both connector 56 and receptacle assembly 50. Connector 56 is disposed on a floating receptacle housing 55, to minimize the shock received by the battery pack 60 and the circuitry 43 if the radio 10 is dropped. Charger circuitry 43 allows charging of battery packs having different voltages, as is well known in the art.

The receptacle housing 55 is flexibly connected to the housing 11 via a flexible gasket 51. Preferably, gasket 51 is generally annular and made of a flexible, resilient material, such as rubber or elastometer.

Retainers 52 may be installed on housing 11 to prevent the disengagement of gasket 51 and housing 11 when pushing the battery pack 60 in place. Retainers 52 may be attached to housing 11 via screws 53 and may have a generally annular form. Retainers 52 may also prevent the removal of receptacle housing 55 when removing the battery pack 60 by providing a stopping surface which would contact the charger circuitry board 43.

A spring 54 may also be provided on door 19 to bias battery pack 60 into connection with connector 56. Preferably spring 54 will be flexible enough to bias battery packs having different sizes.

FIG. 5 is a block diagram of the circuitry within housing 11. Charger circuitry 43 is connected to a power supply 40. Power supply 40 may receive power from an alternating current source via connector 41 and/or from charger 43 when a battery pack is being used as the power source for the radio 10. In addition, power supply 40 provides power to charger 43 in order to charge battery pack 60 even while the radio 10 is in operation.

Power supply 40 also provides power to radio circuitry 44. A switching means 42 may be connected to switch knob 17 to properly select the components receiving power. For example, the user can select if the power supply 40: (a) provides power to both the radio circuitry 44 and to charger 43 (for charging battery pack 60); (b) provides power to the radio circuitry 44 from the battery pack 60; (c) provides no power to any component; etc. Switching means 42 may comprise relays, transistors or other switching devices as is well known in the art. Preferably power supply 40 can accept power from battery packs having different voltages.

Radio circuitry 44 may comprise three main modules: (a) radio tuner 45 for receiving and demodulating the radio signal received via antenna 14; (b) amplifier 46 connected to tuner 45 for amplifying the demodulated radio signal; and (c) speakers 12 connected to amplifier 46 for converting the amplified signal into audible signals. Amplifier 46 may also amplify signals received from an auxiliary input 13, allowing a user to play a separate cassette deck or compact disk player through the radio 10.

Persons skilled in the art should recognize that the specific circuitry for each component is well known in the art. For example, radio circuitry 44 may include an FM Front End integrated circuit, such as the Sanyo LA1186N used in a well-known manner, in combination with a low frequency power amplifier integrated circuit, such as the Toshiba TA8227P used in a well-known manner. Persons skilled in the art are referred to the specifications of these two integrated circuits for further information on the standard usage, capabilites, parameters, etc.

Moreover, the radio circuitry 44 may be replaced with other circuitry for producing audio signals to the speakers via circuitry used with a cassette deck, compact disk or other methods to play music.

Preferably charger 43 is shielded with a metal covering, such as lead, copper, gold, etc., so as to not affect the reception, processing and/or amplification of the radio signal. Similarly, charger 43 can be provided with induction coils, or other types of filters, so as to minimize the effect of the charger on the radio signal, etc.

With such construction, for example, a user can charge a battery pack by disposing the battery pack 60 in the charger 43, providing power to the battery pack 60, and removing the battery pack 60 from the charger 43. The battery pack 60 can then be inserted into a power tool, such as drill 100 (FIG. 5). In other words, the user can listen to the radio 10 while charging the battery pack 60. Alternatively, the user can manually switch the power supply 40 so that the radio circuitry 43 receives the operating power from the battery pack 60, rather than from the alternating current source.

Persons skilled in the art may recognize other alternatives to the means disclosed herein. However, all these additions and/or alterations are considered to be equivalents of the present invention.

## Claims

1. Audio equipment comprising:
a main housing (11); and
a receptacle assembly (50) for receiving a battery (60) via a connector (56) appropriate to contact the battery terminals, wherein the receptacle assembly is flexibly connected to the main housing and comprises a receptacle housing (55) on which the connector (56) is disposed;
**characterised in that** the receptacle housing (55) is flexibly connected to the main housing (11) via a flexible gasket (51), such that the receptacle housing is a floating receptacle housing.

2. Audio equipment according to claim 1 wherein the flexible gasket is made of rubber or elastomer.

3. Audio equipment according to any one of claim 1 or claim 2, wherein the receptacle assembly further comprises at least one retainer (52) disposed on the housing to prevent disengagement of the gasket.

4. Audio equipment according to any one of the preceding claims further comprising charger circuitry (43) for charging the battery, which circuitry is fixedly connected to both the connector and the receptacle assembly.

5. Audio equipment according to any one of the preceding claims, further comprising a door (19) hingeably connected to the main housing and opposite of the receptacle assembly.

6. Audio equipment according to claim 5, wherein the door has a spring disposed thereon to bias a battery disposed in the receptacle assembly towards a connecting position.

## Patentansprüche

1. Audiogerät, Folgendes umfassend:
ein Hauptgehäuse (11); und
eine Behältereinheit (50) zur Aufnahme einer Batterie (60) über einen Stecker (56), der sich zum Kontaktieren der Batterieanschlüsse eignet,
wobei die Behältereinheit flexibel mit dem Hauptgehäuse verbunden ist und ein Behältergehäuse (55) umfasst, an dem der Stecker (56) angeordnet ist;
**dadurch gekennzeichnet, dass** das Behältergehäuse (55) über eine flexible Dichtung (51) mit dem Hauptgehäuse (11) flexibel verbunden ist, so dass es sich bei dem Behältergehäuse um ein schwimmend gelagertes Behältergehäuse handelt.

2. Audiogerät nach Anspruch 1, wobei die flexible Dichtung aus Kautschuk oder Elastomer hergestellt ist.

3. Audiogerät nach Anspruch 1 oder Anspruch 2, wobei die Behältereinheit darüber hinaus mindestens einen Halter (52) umfasst, der am Gehäuse angeordnet ist, um zu verhindern, dass sich die Dichtung löst.

4. Audiogerät nach einem der vorhergehenden Ansprüche, darüber hinaus einen Ladeschaltkreis (43) zum Laden der Batterie umfassend, der fest sowohl an den Stecker als auch die Behältereinheit angeschlossen ist.

5. Audiogerät nach einem der vorhergehenden Ansprüche, darüber hinaus eine Öffnungsklappe (19) umfassend, die entgegengesetzt zur Behältereinheit am Hauptgehäuse angelenkt ist.

6. Audiogerät nach Anspruch 5, wobei an der Öffnungsklappe eine Feder angeordnet ist, um eine in der Behältereinheit angeordnete Batterie zu einer Anschlussposition hin zu beaufschlagen.

## Revendications

1. Équipement audio comprenant :
un boîtier principal (11) ; et
un ensemble de réceptacle (50) pour recevoir une batterie (60) par l'intermédiaire d'un connecteur (56) adapté pour entrer en contact avec les bornes de la batterie, dans lequel l'ensemble de réceptacle est connecté de façon flexible au boîtier principal et comprend un logement de réceptacle (55) sur lequel est disposé le connecteur (56) ;
**caractérisé en ce que** le logement de réceptacle (55) est connecté de façon flexible au boîtier principal (11) via une garniture d'étanchéité flexible (51), de telle sorte que le logement de réceptacle est un logement de réceptacle flottant.

2. Équipement audio selon la revendication 1, dans lequel la garniture d'étanchéité flexible est réalisée en caoutchouc ou en un élastomère.

3. Équipement audio selon l'une quelconque des revendications 1 ou 2, dans lequel l'ensemble de réceptacle comprend, de plus, au moins un moyen de retenue (52) disposé sur le boîtier pour empêcher un dégagement de la garniture d'étanchéité.

4. Équipement audio selon l'une quelconque des revendications précédentes, comprenant de plus un circuit de chargeur (43) pour la recharge de la batterie, circuit qui est connecté, de façon fixée, à la fois au connecteur et à l'ensemble de réceptacle.

5. Équipement audio selon l'une quelconque des revendications précédentes, comprenant, de plus, un volet (19) connecté de façon articulée au boîtier principal et opposé à l'ensemble de réceptacle.

6. Équipement audio selon la revendication 5, dans lequel le volet présente un ressort disposé dessus pour pousser une batterie placée dans l'ensemble de réceptacle vers une position de connexion.
